# EUROPEAN PATENT SPECIFICATION

(11) **EP 0 999 291 B1**
(45) Date of publication and mention of the grant of the patent: **26.05.2004**
(21) Application number: 99118152.0
(22) Date of filing: 11.09.1999
(51) Int. Cl.: C23C 14/16, G11B 5/64, C23C 14/34

(54) **Method for producing thin film coated magnetic disks and thin film magnetic disks thus obtained**
Verfahren zum Herstellen mit Dünnschichten beschichteter Magnetplatten sowie dadurch erhaltene Dünnschichtmagnetplatten
Procédé de fabrication de disques magnétiques revêtus de films minces et disques magnétiques à film mince ainsi obtenus

(30) Priority: 05.11.1998 DE 19851062
(43) Date of publication of application: 10.05.2000
(73) Proprietor: International Business Machines Corporation, Armonk, NY 10504 (US); Fraunhofer-Gesellschaft zur Förderung der angewandten Forschung e.V., 80686 München (DE)
(72) Inventor: Buchberger, Hans, 61476 Kronberg (DE); Müller, Manfred, 55270 Essenheim (DE); Schneider, Hans-Hermann, 55262 Heidesheim (DE); Baur, Heinz, 55129 Mainz (DE); Lehnert, Karl-Heinz, 55124 Mainz (DE); Goedicke, Klaus, 01307 Dresden (DE); Winkler, Torsten, 01454 Radeberg (DE); Junghähnel, Michael, 01324 Dresden (DE); Blüthner, Ralf, 01445 Radebeul (DE)
(74) Representative: Rach, Werner, Dr.

(56) References cited:
- WO-A-98/32128
- US-A- 5 300 205
- US-A- 5 456 978

## Description

The invention concerns a method for coating thin film coated magnetic disks of high storage density for use in hard magnetic disks, by means of magnetron sputtering, and a thin film magnetic disk produced using this method.

The methods of producing thin film magnetic disks in vertical continuous coaters for a large number of substrates to be coated together, or in single disk coaters, are already known. The substrates for the production of thin film magnetic disks consist of glass or of highly polished aluminium disks galvanised with a nickel-phosphorous coating. In future, various alternative materials such as aluminium borocarbide will be used.

Irrespective of the substrate material, a number of thin coats are applied by physical and/or chemical atomisation of the coats. These are base coats, mostly consisting of chromium, magnetic storage layers, mostly consisting of composite alloys of cobalt, chromium and other metals, and a top coat, mostly consisting of carbon. DC magnetron sputtering is the most commonly used coating method in the production of thin film magnetic disks.

For high-quality thin film magnetic disks, a storage density in excess of 3 Gbit/in² is required. The resulting flying heads of the magnetic heads are below 40 nm. A reduction in noise and in holidays on the storage surface and effective adaptation to the heads are pre-requisites for the realisation of this storage density.

The method of achieving the low flying heads by improving the topography of the surface of the finished thin film magnetic disk and reducing the thickness of the coatings, especially the magnetic coat and the top coat, is already known. By using new alloys for the magnetic storage layer and specially adapted underlying structures, thin film magnetic disks with coercive field strengths of > 1,99 x 10⁵ A/m (2500 Oe) and remanent magnetisation layer thickness (Mrt) of ≥ 0.5 can be produced with good reproducibility.

New problems, not previously encountered, have arisen chiefly due to demands for increasing storage density and reducing the thickness of the coatings.

A decisive shortcoming is the fact that increased corrosion occurs with the use of aluminium substrates. This corrosion gives rise to blooming and warping on the surface of the magnetic disk, which results in areas which can no longer be written on or read. There is a danger that these may come into contact with the heads, as the flying head is around the same height as the blooming. Two factors have an effect on corrosion. On the one hand, errors in polishing the substrates and residues from wet processes are triggers for corrosion. On the other hand, the atomised coats are only tight and non-porous to a limited extent. Amongst other things, the reduction in coat thickness from 30 nm to 10 nm has the effect of worsening corrosion behaviour. The top coat can only perform the function of the mechanical protection of the magnetic coat against contact with the heads and, in conjunction with the lubricant, safeguards the sliding capability of the heads. (The problem of corrosion is described in detail by Chia, Wang, Tang and Lee in "Overview of accelerated corrosion tests on thin film magnetic media" in The Minerals, Metals & Materials Society, 1998, p. 311-319.) Although the substrates are polished to a mirror finish, the topography of the finished magnetic disks is less than ideal. Microscopic cracks and pinholes can be detected.These defects on the surface of the substrates stand in the way of optimum cleaning during the washing process. This decreases the evenness of the atomisation of the coats and results in less effective covering of the edges.

It is known that corrosion can be reduced by increasing the thickness of the base coat and applying a negative direct current to the substrate during the atomisation of the base coat.

Neither measure solves the problem. They only reduce the number of corrosion points revealed in acid tests with HCl or HNO₃. The usefulness of the measures is not unlimited. The increase in thickness of the base coat is in contrast to the requirements as regards magnetism. The application of a negative direct current to the substrate can only be used in the case of conductive substrates.

The basis of the invention lies in the task of creating a method of coating thin film magnetic disks by improving the production thereof to such an extent that, in the case of metallic substrates, the corrosion resistance of magnetic disks is significantly increased and, in the case of non-metallic substrates, the diffusion of water to the substrate and of freely moveable ions from the substrate is drastically reduced. The method is intended for use with all substrate materials - both conductive and insulating. It is intended that the method can be implemented for industrial use in the usual coating plants. A further task of the invention is to create a thin film magnetic disk with increased corrosion resistance.

In accordance with the invention, the task is solved according to the features of claims 1 and 9. Further advantageous basic features of the method are described in claims 2 to 8.

The finding was the placing of a barrier layer between the substrate and the series of magnetic coatings in such a way that the magnetic values such as coercive field strength and remanent magnetisation layer thickness are not influenced. This reduces the corrosion resistance to such an extent that practically no holidays caused by corrosion can be detected on the magnetic disks using known testing methods. This represents an improvement by one to two orders. Surprisingly, the effect is achieved at a thickness as low as just a few nm. In accordance with the method, aluminium or chromium are the preferred materials for application as barrier layers.

Very good properties are achieved where the process gas contains a proportion of oxygen and/or nitrogen. The increase in coercive field strength which can be noted in the pulsed atomisation of the base coat is not activated when the barrier layer in accordance with the invention is used. Spraying on a chromium coating for the barrier layer is very advantageous, as the crystal formation in the subsequent steps is not disturbed.

It is of particular advantage that the effect of the barrier layer can be adapted to the relevant substrate material by means of the choice of material to be atomised, the variation in coating thickness and the selection of the frequency and pulse ratio for the sputtering process. A frequency of 50 kHz has been shown to be particularly suitable. This frequency evidently brings about a favourable atomisation rate to plasma excitation ratio, to atomise very tight, defect-free coats with a high yield of sputtered excited particles. The freedom from defects here relates to coats without pinholes or a columnar structure.

The method in accordance with the invention can be implemented for all magnetic disk coaters. This suitability for integration into production plants is a great advantage of the method.

The invention will be illustrated in more detail using an example of embodiment.

A single disk coater, which is in itself known, is used to atomise a series of magnetic coats and a barrier layer on an aluminium substrate which has a protective coating of nickel phosphorous, applied galvanically, to produce thin film magnetic disks. As proof of the effectiveness of the method in accordance with the invention, a standard process is drawn on. For the coated thin film magnetic disks, the magnetic properties and the properties of the barrier layer are determined. These values must be within the specified tolerances. A sample of the coated magnetic disks is subjected to an acid test using HNO₃ in order to evaluate the corrosion resistance.

After the reference samples have been prepared, the thin film magnetic disks are produced in accordance with the invention. To do this, in addition to the process steps used hitherto: heating, atomisation of the base coat, atomisation of the magnetic coats and atomisation of the protective coating, a further process step of applying the barrier layer is introduced after the heating stage. Here, the substrates are heated to 220°C, and a barrier layer is atomised before atomisation of the base coat.

The process time for the atomisation of the barrier layer is 4 seconds at a pressure of 0.8 Pa. Oxygen with a partial pressure of 0.1 Pa is mixed in with the inert carrier gas. An aluminium target with a standard magnetron arrangement is used. The energy is pulsed into the plasma. The pulse frequency is 50 kHz, and the pulse length to pulse gap ratio is adjusted to 1:1. The resulting plasma switching on time is 10 µs and the gap is also 10 µs. The primary power, i.e. the power fed into the pulsing device, is 150 W averaged over time.

The method in accordance with the invention has also shown that, with a pulse length of 14 µsec and cycle duration of 20 µsec the positive effect starts to decrease once more, i.e. the corrosion holidays start to increase sharply again.

The table shows measurement values for magnetic properties and measured corrosion values. The introduction of a very tight, pinhole-free barrier layer atomised by means of medium frequency pulsed magnetron sputtering improves corrosion behaviour by one to two orders. The application of a negative direct current to the substrate during atomisation of the barrier layer further improves corrosion resistance. The magnetic values of coercive field strength and remanent magnetisation layer thickness do not change when the method is carried out using the stated parameters (see table below)

| | Barrier | Pulse ratio for barrier | Substrate bias | Corrosion points per disk | Hc [Oe] average values | Md average values |
|---|---|---|---|---|---|---|
| Standard | no | | no | 85 - 105 | 2,07x 10⁵ 2595 | 0.59 |
| Variant 1 | yes | 1:1 | no | 1 - 4 | 2,05x 10⁵ 2575 | 0.61 |
| Variant 2 | yes | 1:1 | yes | 0 - 2 | 2,08x 10⁵ 2610 | 0.6 |

The greatest effect is achieved by the introduction of the barrier layer in accordance with the invention in itself. Variant 1 shows that the number of corrosion points which are discovered in the course of a HNO₃ test is very small compared with the standard process. Variant 2 shows that the atomisation of the barrier layer with a negative direct current applied to the substrate produces a further improvement.

## Claims

1. Method for coating thin film magnetic disks by magnetron sputtering, comprising a substrate, on which a series of layers consisting of base coats, magnetic coats, intermediate coats and a top coating is applied, **characterized in that** between the substrate and the first base coating of the series of coatings a barrier layer is applied by medium-frequency sputtering at a frequency between 10 and 200 kHz, preferably 50 kHz and with a pulse length to pulse gap ratio in the region of 5:1 to 1:10.

2. Method in accordance with Claim 1, **characterised in that** the barrier layer is deposited by atomising a chromium target.

3. Method in accordance with Claim 1 and 2, **characterised in that** the pressure on atomising the barrier layer is adjusted to 0.1 to 1.5 Pa, preferably to 0.5 Pa.

4. Method in accordance with Claim 1 to 3, **characterised in that** during the atomisation of the barrier layer other gases, preferably reactive gases such as oxygen and/or nitrogen, are mixed with the carrier gas.

5. Method in accordance with Claim 1 to 4, **characterised in that** a thin layer is applied to the substrate to be coated before atomising the barrier layer.

6. Method in accordance with Claim 1 to 5, **characterised in that** a direct current of -50 V to -500 V, preferably - 200 V is applied to the substrate during the atomisation of the barrier layer.

7. Method in accordance with Claim 1 to 5, **characterised in that** a pulsed voltage, preferably with a frequency of 50 kHz is applied to the substrate during the atomisation of the barrier layer.

8. Method in accordance with Claim 1 to 5, **characterised in that** a high frequency alternating current with a frequency of preferably 13.56 MHz is applied to the substrate during the atomisation of the barrier layer.

9. Thin film magnetic disk comprising a substrate, on which a series of layers consisting of base coats, magnetic coats, intermediate coats and a top coating is applied, **characterized in that** a barrier coating is applied between the substrate and the first base coating by medium frequency pulsed magnetron sputtering.

## Patentansprüche

1. Verfahren zum Beschichten magnetischer Dünnschichtplatten durch Magnetronsputtern, das ein Substrat beinhaltet, auf das eine Serie von Schichten aufgebracht wird, die aus Basisbeschichtungen, magnetischen Beschichtungen, Zwischenbeschichtungen und einer oberen Beschichtung bestehen, **dadurch gekennzeichnet, dass** zwischen dem Substrat und der ersten Basisbeschichtung der Serie von Beschichtungen eine Barrierenschicht durch Mittelfrequenzsputtern bei einer Frequenz zwischen 10 kHz und 200 kHz, vorzugsweise 50 kHz, und mit einem Verhältnis von Impulslänge zu Impulslücke im Bereich von 5:1 bis 1:10 aufgebracht wird.

2. Verfahren nach Anspruch 1, **dadurch gekennzeichnet, dass** die Barrierenschicht durch Atomisieren eines Chromtargets aufgebracht wird.

3. Verfahren nach den Ansprüchen 1 und 2, **dadurch gekennzeichnet, dass** der Druck beim Atomisieren der Barrierenschicht auf 0,1 Pa bis 1,5 Pa eingestellt wird, vorzugsweise auf 0,5 Pa.

4. Verfahren nach den Ansprüchen 1 bis 3, **dadurch gekennzeichnet, dass** während des Atomisierens der Barrierenschicht weitere Gase, vorzugsweise reaktive Gase wie Sauerstoff und/oder Stickstoff, mit dem Trägergas gemischt werden.

5. Verfahren nach den Ansprüchen 1 bis 4, **dadurch gekennzeichnet, dass** eine dünne Schicht an dem zu beschichtenden Substrat vor dem Atomisieren der Barrierenschicht angebracht wird.

6. Verfahren nach den Ansprüchen 1 bis 5, **dadurch gekennzeichnet, dass** ein Gleichstrom von -50 V bis -500 V, vorzugsweise -200 V, während des Atomisierens der Barrierenschicht an das Substrat angelegt wird.

7. Verfahren nach den Ansprüchen 1 bis 5, **dadurch gekennzeichnet, dass** eine gepulste Spannung, vorzugsweise mit einer Frequenz von 50 kHz, während des Atomisierens der Barrierenschicht an das Substrat angelegt wird.

8. Verfahren nach den Ansprüchen 1 bis 5, **dadurch gekennzeichnet, dass** ein Hochfrequenzwechselstrom mit einer Frequenz von vorzugsweise 13,56 MHz während des Atomisierens der Barrierenschicht an das Substrat angelegt wird.

9. Magnetische Dünnschichtplatte mit einem Substrat, auf das eine Serie von Schichten aufgebracht ist, die aus Basisbeschichtungen, magnetischen Beschichtungen, Zwischenbeschichtungen und einer oberen Beschichtung besteht, **dadurch gekennzeichnet, dass** eine Barrierenbeschichtung zwischen dem Substrat und der ersten Basisbeschichtung durch gepulstes Magnetronsputtern bei mittlerer Frequenz aufgebracht wird.

## Revendications

1. Procédé pour revêtir des disques magnétiques à film mince au moyen d'une pulvérisation par magnétron, comprenant un substrat, sur lequel une série de couches consistant en revêtements de base, des revêtements magnétiques, des revêtements intermédiaires et un revêtement supérieur est appliquée, **caractérisé en ce que**, entre le substrat et le premier revêtement de base de la série de revêtements, une couche de barrière est appliquée au moyen d'une pulvérisation à moyenne fréquence, à une fréquence comprise entre 10 et 200 kHz, de préférence 50 kHz, et avec un rapport durée d'impulsion sur intervalle d'impulsions dans la plage de 5:1 à 1:10.

2. Procédé selon la revendication 1, **caractérisé en ce que** la couche de barrière est déposée en atomisant une cible de chrome.

3. Procédé selon les revendications 1 et 2, **caractérisé en ce que** la pression, lors de l'atomisation de la couche de barrière, est réglée entre 0,1 et 1,05 Pa, de préférence à 0,5 Pa.

4. Procédé selon les revendications 1 à 3, **caractérisé en ce que**, pendant l'atomisation de la couche de barrière, d'autres gaz, de préférence des gaz réactifs tels que de l'oxygène et/ou de l'azote, sont mélangés au gaz porteur.

5. Procédé selon les revendications 1 à 4, **caractérisé en ce qu'**une couche mince est appliquée au substrat devant être revêtu avant d'atomiser la couche de barrière.

6. Procédé selon les revendications 1 à 5, **caractérisé en ce qu'**un courant continu de -50 V à -500 V, de préférence - 200 V, est appliqué au substrat pendant l'atomisation de la couche de barrière.

7. Procédé selon les revendications 1 à 5, **caractérisé en ce qu'**une tension pulsée, de préférence à une fréquence de 50 kHz, est appliquée au substrat pendant l'atomisation de la couche de barrière.

8. Procédé selon les revendications 1 à 5, **caractérisé en ce qu'**un courant alternatif à haute fréquence, de préférence à une fréquence de 13,56 MHz, est appliqué au substrat pendant l'atomisation de la couche de barrière.

9. Disque magnétique à film mince comprenant un substrat, sur lequel une série de couches consistant en des revêtements de base, des revêtements magnétiques, des revêtements intermédiaires et un revêtement supérieur est appliquée, **caractérisé en ce qu'**un revêtement de barrière est appliqué entre le substrat et le premier revêtement de base par pulvérisation par magnétron pulsé à fréquence moyenne.
